(19) Europäisches Patentamt
European Patent Office
Office européen des brevets

(11) EP 4 583 176 A2

(12) EUROPEAN PATENT APPLICATION

(43) Date of publication:
**09.07.2025 Bulletin 2025/28**

(21) Application number: **25164264.1**

(22) Date of filing: **21.10.2022**

(51) International Patent Classification (IPC):
***H01M 4/02*** *(2006.01)*

(52) Cooperative Patent Classification (CPC):
**H01M 4/1393; H01M 4/1395; H01M 4/366; H01M 4/386; H01M 4/62;** H01M 10/052; H01M 2004/027; Y02E 60/10

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **21.10.2021 GB 202115161**

(62) Document number(s) of the earlier application(s) in accordance with Art. 76 EPC:
**22797461.5 / 4 341 213**

(71) Applicant: **Nexeon Limited**
**Abingdon, Oxfordshire OX14 4SB (GB)**

(72) Inventors:
- **WHITTAM, Joshua**
  **Abingdon, OX14 4SB (GB)**
- **FRIEND, Christopher**
  **Abingdon, OX14 4SB (GB)**
- **MASON, Charles**
  **Abingdon, OX14 4SB (GB)**
- **CHIACCHIA, Mauro**
  **Abingdon, OX14 4SB (GB)**
- **MEOTO, Silo**
  **Abingdon, OX14 4SB (GB)**

(74) Representative: **Gill Jennings & Every LLP**
**The Broadgate Tower**
**20 Primrose Street**
**London EC2A 2ES (GB)**

Remarks:
•This application was filed on 17-03-2025 as a divisional application to the application mentioned under INID code 62.
•Claims filed after the date of filing of the application (Rule 68(4) EPC).

# (54) PROCESS FOR PREPARING ELECTROACTIVE MATERIALS FOR METAL-ION BATTERIES

(57) This invention relates a process for preparing composite particles. The process comprises a first step of providing a plurality of porous particles comprising micropores and/or mesopores, wherein the total pore volume of micropores and mesopores as measured by nitrogen gas adsorption is in the range from 0.4 to 2.2 $cm^3/g$. The porous particles are contacted with a precursor of an electroactive material at a temperature effective to cause deposition of the electroactive material in the pores of the porous particles to form intermediate particles. Deposition of the electroactive material is discontinued and byproducts are optionally separated from the intermediate particles. The intermediate particles are then contacted with a precursor of an electroactive material, at a temperature effective to cause further deposition of the electroactive material in the pores of the intermediate particles to form the composite particles. In at least one of the deposition steps, the reactor pressure is maintained at less than 200 kPa.



Processed by Luminess, 75001 PARIS (FR)

## Description

This invention relates in general to a process for preparing electroactive materials that are suitable for use in electrodes for rechargeable metal-ion batteries, and more specifically to particulate materials having high electrochemical capacities that are suitable for use as anode active materials in rechargeable metal-ion batteries.

Rechargeable metal-ion batteries are widely used in portable electronic devices such as mobile telephones and laptops and are finding increasing application in electric or hybrid vehicles. Rechargeable metal-ion batteries generally comprise an anode in the form of a metal current collector provided with a layer of an electroactive material, defined herein as a material which is capable of inserting and releasing metal ions during the charging and discharging of a battery. The terms "cathode" and "anode" are used herein in the sense that the battery is placed across a load, such that the anode is the negative electrode. When a metal-ion battery is charged, metal ions are transported from the metal-ion-containing cathode layer via the electrolyte to the anode and are inserted into the anode material. The term "battery" is used herein to refer both to a device containing a single anode and a single cathode and to devices containing a plurality of anodes and/or a plurality of cathodes.

There is interest in improving the gravimetric and/or volumetric capacities of rechargeable metal-ion batteries. To date, commercial lithium-ion batteries have largely been limited to the use of graphite as an anode active material. When a graphite anode is charged, lithium intercalates between the graphite layers to form a material with the empirical formula $Li_xC_6$ (wherein x is greater than 0 and less than or equal to 1). Consequently, graphite has a maximum theoretical capacity of 372 mAh/g in a lithium-ion battery, with a practical capacity that is somewhat lower (ca. 340 to 360 mAh/g). Other materials, such as silicon, tin and germanium, are capable of intercalating lithium with a significantly higher capacity than graphite but have yet to find widespread commercial use due to difficulties in maintaining sufficient capacity over numerous charge/discharge cycles.

Silicon in particular has been identified as a promising alternative to graphite for the manufacture of rechargeable metal-ion batteries having high gravimetric and volumetric capacities because of its very high capacity for lithium (see, for example, Insertion Electrode Materials for Rechargeable Lithium Batteries, Winter, M. et al. in Adv. Mater. 1998, 10, No. 10). At room temperature, silicon has a theoretical maximum specific capacity in a lithium-ion battery of about 3,600 mAh/g (based on $Li_{15}Si_4$). However, the intercalation of lithium into bulk silicon leads to a large increase in the volume of the silicon material of up to 400% of its original volume when silicon is lithiated to its maximum capacity. Repeated charge-discharge cycles cause significant mechanical stress in the silicon material, resulting in fracturing and delamination of the silicon anode material. Volume contraction of silicon particles upon delithiation can result in a loss of electrical contact between the anode material and the current collector. A further difficulty is that the solid electrolyte interphase (SEI) layer that forms on the silicon surface does not have sufficient mechanical tolerance to accommodate the expansion and contraction of the silicon. As a result, newly exposed silicon surfaces lead to further electrolyte decomposition and increased thickness of the SEI layer and irreversible consumption of lithium. These failure mechanisms collectively result in an unacceptable loss of electrochemical capacity over successive charging and discharging cycles.

A number of approaches have been proposed to overcome the problems associated with the volume change observed when charging silicon-containing anodes. It has been reported that fine silicon structures below around 150 nm in cross-section, such as silicon films and silicon nanoparticles are more tolerant of volume changes on charging and discharging when compared to silicon particles in the micron size range. However, neither of these is suitable for commercial scale applications in their unmodified form; nanoscale particles are difficult to prepare and handle and silicon films do not provide sufficient bulk capacity.

WO 2007/083155 discloses that improved capacity retention may be obtained with silicon particles having high aspect ratio, i.e. the ratio of the largest dimension to the smallest dimension of the particle. The small cross-section of such particles reduces the structural stress on the material due to volumetric changes on charging and discharging. However, such particles may be difficult and costly to manufacture and can be fragile. In addition, high surface area may result in excessive SEI formation, resulting in excessive loss of capacity on the first charge-discharge cycle.

It is also known in general terms that electroactive materials such as silicon may be deposited within the pores of a porous carrier material, such as an activated carbon material. These composite materials provide some of the beneficial charge-discharge properties of nanoscale silicon particles while avoiding the handling difficulties of nanoparticles. Guo et al. (Journal of Materials Chemistry A, 2013, pp.14075-14079) discloses a silicon-carbon composite material in which a porous carbon substrate provides an electrically conductive framework with silicon nanoparticles deposited within the pore structure of the substrate with uniform distribution. It is shown that the composite material has improved capacity retention over multiple charging cycles, however the initial capacity of the composite material in mAh/g is significantly lower than for silicon nanoparticles.

The present inventors have previously reported the development of a class of electroactive materials having a composite structure in which nanoscale electroactive materials, such as silicon, are deposited into the pore network of a highly porous particulate material, e.g. a porous carbon material.

For example, WO 2020/095067 and WO 2020/128495 report that the improved electrochemical performance of

these materials can be attributed to the way in which the electroactive materials are located in the porous material in the form of small domains with dimensions of the order of a few nanometres or less. These fine electroactive structures are thought to have a lower resistance to elastic deformation and higher fracture resistance than larger electroactive structures, and are therefore able to lithiate and delithiate without excessive structural stress. As a result, the electroactive materials exhibit good reversible capacity retention over multiple charge-discharge cycles. Secondly, by controlling the loading of silicon within the porous carbon framework such that only part of the pore volume is occupied by silicon in the uncharged state, the unoccupied pore volume of the porous carbon framework is able to accommodate a substantial amount of silicon expansion internally. Furthermore, by locating nanoscale silicon domains within small mesopores and/or micropores as described above, only a small area of silicon surface is accessible to electrolyte and so SEI formation is limited. Additional exposure of silicon in subsequent charge-discharge cycles is substantially prevented such that SEI formation is not a significant failure mechanism leading to capacity loss. This stands in clear contrast to the excessive SEI formation that characterizes the material disclosed by Guo, for example (see above).

The materials described in WO 2020/095067 and WO 2020/128495 has been synthesized by chemical vapour infiltration (CVI) in different reactor systems (static, rotary and FBR). The porous particles are contacted with a flow of a silicon-containing precursor (CVI), typically silane gas, at atmospheric pressure and at temperatures between 400 to 700 °C.

There remains a need in the art for improved processes for the production of electroactive materials with improved performance.

In a first aspect, the invention provides a process for preparing composite particles, the process comprising the steps of:

(a) providing a plurality of porous particles comprising micropores and/or mesopores, wherein the total pore volume of micropores and mesopores as measured by nitrogen gas adsorption is in the range from 0.4 to 2.2 $cm^3/g$;
(b) contacting the porous particles with a precursor of an electroactive material at a temperature effective to cause deposition of the electroactive material in the pores of the porous particles to form intermediate particles;
(c) discontinuing deposition of the electroactive material and optionally separating by-products from the intermediate particles;
(d) contacting the intermediate particles from step (c) with a precursor of an electroactive material, at a temperature effective to cause further deposition of the electroactive material in the pores of the intermediate particles to form the composite particles;

wherein the reactor pressure in at least one of steps (b) and (d) is maintained at less than 200 kPa.

The invention therefore relates in general terms to a process for preparing a composite particulate material in which an electroactive material is deposited into the pores of a porous particle material in at least two separate steps. An initial deposition of electroactive material takes place in step (b) and further deposition of electroactive material takes place in step (d). Optionally, steps (c) and (d) may be repeated multiple times such that the process of the invention comprises depositing the electroactive material over three or more steps.

Steps (b) and (d) use chemical vapour infiltration (CVI) of a precursor of an electroactive material to deposit the first and second electroactive material layers onto the pore surfaces of the porous particles. Chemical vapour infiltration (CVI) is a process of infiltrating a porous material with an additional phase, typically by contacting a reactive gaseous precursor with the porous material at high temperature. Decomposition/reaction of the reactive gaseous precursor on pore surfaces results in the deposition of a solid phase within the pores.

By depositing the electroactive material in multiple steps, the deposition of the electroactive material is interrupted by one or more steps (step (c)) where the deposition of electroactive material is discontinued. The discontinuation of deposition of electroactive material at an intermediate stage of the total deposition allows for a number of improvements when compared to a process in which all of the electroactive material is deposited in a single step.

Firstly, the deposition of the electroactive material in at least two separate steps allows for different deposition conditions to be used in each steps. This allows for greater control over the CVI process at different stages of the total deposition. Deposition of electroactive material in a CVI process occurs at the surfaces of the porous particles. In view of the very high internal surface area of the porous particles, the reaction kinetics favour deposition of the electroactive material almost entirely within the pores of the porous particles.

However, an important factor in controlling the deposition of the electroactive material is mass transfer of the precursor from the exterior of the particles to the location where deposition takes place. When mass transfer becomes a limiting factor in the CVI process, the electroactive material may be deposited in larger pores or on the outer surfaces of the electroactive material. Furthermore, the deposited electroactive material may then block access to smaller pore spaces where the electroactive material would desirably be deposited. Carrying out at least one of steps (b) and (d) at a pressure of less than 200 kPa results in increased diffusivity of the precursor of the electroactive material, allowing it to access micropores and/or the smallest mesopores prior to thermal decomposition. Accordingly, control of the pressure of at least

one of steps (b) and (d) as set out herein allows for improved control of the deposition of the electroactive material.

Secondly, the discontinuation of the deposition of electroactive material at an intermediate stage allows for additional process steps to be carried out between successive depositions of electroactive material. One advantageous process step comprises the separation from the intermediate particles formed in step (b) of by-products from the intermediate particles formed in step (b). When the deposition of electroactive material is carried out in a single step, it is necessary for by-products to diffuse out of the pore volume of the porous particles at the same time as the precursor of the electroactive material is required to diffuse into the pore volume. As a consequence, removal of by-products is inefficient and by-products can become incorporated into the deposited electroactive material resulting in impaired electrochemical performance. The discontinuation of the deposition of the electroactive material provides an opportunity for by-products to diffuse out of the porous particles and be removed before deposition is continued. As a result, the quality of the deposited material is improved, resulting in improved electrochemical performance when the composite particles are incorporated into an electrode.

The discontinuation of the deposition of electroactive material at an intermediate stage also allows for other materials to be formed on the surfaces of the electroactive material deposited in step (b). These materials are referred to herein generally as "modifier materials". A suitable modifier material may comprise a material formed by a chemical modification of the surface of the electroactive material deposited in step (b). Another suitable modifier material may comprise another deposited material, wherein the deposited material is non-electroactive. The modifier materials may create an at least partial barrier between the electroactive materials deposited in steps (b) and (d). As a result, the length scale of any continuous domain of electroactive material may be limited by an intervening domain of modifier material. It has been found that larger domains of electroactive material result in poor electrochemical performance. Accordingly, the use of modifier materials to interrupt the domains of electroactive material allows the length scale of individual electroactive material domains to be controlled, while still allowing for a high overall content of electroactive material in the composite particles.

The porous particles function as a framework for the electroactive material, which is typically deposited in the form of a plurality of electroactive material domains. the term "electroactive material domain" refers to a body of electroactive material, e.g. elemental silicon, having maximum dimensions that are determined by the dimensions of the micropores and/or mesopores of the porous particles in which they are located. The electroactive domains may therefore be described as nanoscale electroactive domains, wherein the term "nanoscale" is understood to refer generally to dimensions less than 100 nm. Although, due to the dimensions of micropores and mesopores, the electroactive material domains typically have maximum dimensions in any direction of less than 50 nm, and usually significantly less than 50 nm. A domain may for example take the form of a regular or irregular particle or a bounded layer or region of coating.

The porous particles preferably comprise a conductive material. The use of conductive porous particles is advantageous as the porous particles form a conductive framework within the composite particles which facilitates the flow of electrons between lithium atoms/ions inserted into the electroactive material and a current collector.

A preferred type of conductive porous particles are particles comprising or consisting of a conductive carbon material, referred to herein as conductive porous carbon particles.

The conductive porous carbon particles preferably comprise at least 80 wt% carbon, more preferably at least 90 wt% carbon, more preferably at least 95 wt% carbon, and optionally at least 98wt% or at least 99 wt% carbon. The carbon may be crystalline carbon or amorphous carbon, or a mixture of amorphous and crystalline carbon. The porous carbon particles may be either hard carbon particles or soft carbon particles.

As used herein, the term "hard carbon" refers to a disordered carbon matrix in which carbon atoms are found predominantly in the $sp^2$ hybridised state (trigonal bonds) in nanoscale polyaromatic domains. The polyaromatic domains are cross-linked with a chemical bond, e.g. a C-O-C bond. Due to the chemical cross-linking between the polyaromatic domains, hard carbons cannot be converted to graphite at high temperatures. Hard carbons have graphite-like character as evidenced by the large G-band (~1600 $cm^{-1}$) in the Raman spectrum. However, the carbon is not fully graphitic as evidenced by the significant D-band (~1350 $cm^{-1}$) in the Raman spectrum.

As used herein, the term "soft carbon" also refers to a disordered carbon matrix in which carbon atoms are found predominantly in the $sp^2$ hybridised state (trigonal bonds) in polyaromatic domains having dimensions in the range from 5 to 200 nm. In contrast to hard carbons, the polyaromatic domains in soft carbons are associated by intermolecular forces but are not cross-linked with a chemical bond. This means that they will graphitise at high temperature. The porous carbon particles preferably comprise at least 50% $sp^2$ hybridised carbon as measured by XPS. For example, the porous carbon particles may suitably comprise from 50% to 98% $sp^2$ hybridised carbon, from 55% to 95% $sp^2$ hybridised carbon, from 60% to 90% $sp^2$ hybridised carbon, or from 70% to 85% $sp^2$ hybridised carbon.

A variety of different materials may be used to prepare suitable porous carbon particles via pyrolysis. Examples of organic materials that may be used include plant biomass including lignocellulosic materials (such as coconut shells, rice husks, wood etc.) and fossil carbon sources such as coal. Examples of resins and polymeric materials which form porous carbon particles on pyrolysis include phenolic resins, novolac resins, pitch, melamines, polyacrylates, polystyrenes, polyvinylalcohol (PVA), polyvinylpyrrolidone (PVP), and various copolymers comprising monomer units of acrylates,

styrenes, α-olefins, vinyl pyrrolidone and other ethylenically unsaturated monomers. A variety of different carbon materials are available in the art depending on the starting material and the conditions of the pyrolysis process. Porous carbon particles of various different specifications are available from commercial suppliers.

Porous carbon particles may undergo a chemical or gaseous activation process to increase the volume of mesopores and micropores. A suitable activation process comprises contacting pyrolyzed carbon with one or more of oxygen, steam, CO, $CO_2$ and KOH at a temperature in the range from 600 to 1000 °C.

Mesopores can also be obtained by known templating processes, using extractable pore formers such as MgO and other colloidal or polymer templates which can be removed by thermal or chemical means post pyrolysis or activation.

Alternatives to carbon-based conductive particles include porous particles comprising titanium nitride (TiN), titanium carbide (TiC), silicon carbide (SiC), nickel oxide (NiOx), titanium silicon nitride (TiSiN), nickel nitride ($Ni_3N$), molybdenum nitride (MoN), titanium oxynitride ($TiO_xN_{1-x}$), silicon oxycarbide (SiOC), boron nitride (BN), or vanadium nitride (VN). Preferably the porous particles comprise titanium nitride (TiN), silicon oxycarbide (SiOC) or boron nitride (BN).

The porous particles comprise a three-dimensionally interconnected open pore network comprising micropores and/or mesopores and optionally a minor volume of macropores. In accordance with conventional IUPAC terminology, the term "micropore" is used herein to refer to pores of less than 2 nm in diameter, the term "mesopore" is used herein to refer to pores of 2-50 nm in diameter, and the term "macropore" is used to refer to pores of greater than 50 nm diameter.

References herein to the volume of micropores, mesopores and macropores in the porous particles, and also any references to the distribution of pore volume within the porous particles, relate to the internal pore volume of the porous particles used as the starting material in step (a) of the claimed process, i.e. prior to deposition of electroactive material into the pore volume in step (b).

The porous particles are characterised by a total volume of micropores and mesopores (i.e. the total pore volume in the pore diameter range from 0 to 50 nm) in the range from 0.4 to 2.2 $cm^3/g$. Typically, the porous particles include both micropores and mesopores. However, it is not excluded that porous particles may be used which include micropores and no mesopores, or mesopores and no micropores.

More preferably, the total volume of micropores and mesopores in the porous particles is at least 0.45 $cm^3/g$, or at least 0.5 $cm^3/g$, at least 0.55 $cm^3/g$, or at least 0.6 $cm^3/g$, or at least 0.65 $cm^3/g$, or at least 0.7 $cm^3/g$, or at least 0.75 $cm^3/g$, or at least 0.8 $cm^3/g$, at least 0.85 $cm^3/g$, or at least 0.9 $cm^3/g$, or at least 0.95 $cm^3/g$, or at least 1 $cm^3/g$. The use of high porosity particles may be advantageous since it allows a larger amount of electroactive material to be accommodated within the pore volume.

The internal pore volume of the porous particles is suitably capped at a value at which increasing fragility of the particles structure outweighs the advantage of increased pore volume accommodating a larger amount of electroactive material. Preferably, the total volume of micropores and mesopores in the porous particles is no more than 2 $cm^3/g$, or no more than 1.8 $cm^3/g$, or no more than 1.6 $cm^3/g$, or no more than 1.5 $cm^3/g$, or no more than 1.45 $cm^3/g$, or no more than 1.4 $cm^3/g$, or no more than 1.35 $cm^3/g$, or no more than 1.3 $cm^3/g$, or no more than 1.25 $cm^3/g$, or no more than 1.2 $cm^3/g$, or no more than 1.1, or no more than 1, or no more than 0.95.

Preferably the total volume of micropores and mesopores in the porous particles is in the range from 0.45 to 2.2 $cm^3/g$, or from 0.5 to 2 $cm^3/g$, or from 0.55 to 2 $cm^3/g$, or from 0.6 to 1.8 $cm^3/g$, or from 0.65 to 1.8 $cm^3/g$, or from 0.7 to 1.6 $cm^3/g$, or from 0.7 to 1.5 $cm^3/g$, or from 0.7 to 1.4 $cm^3/g$.

The total volume of micropores and mesopores in the porous particles may also be in the range from 0.55 to 1.4 $cm^3/g$, or from 0.6 to 1.4 $cm^3/g$, or from 0.6 to 1.3 $cm^3/g$, or from 0.65 to 1.3 $cm^3/g$, or from 0.65 to 1.2 $cm^3/g$, or from 0.7 to 1.2 $cm^3/g$, or from 0.7 to 1.1 $cm^3/g$, or from 0.7 to 1 $cm^3/g$, or from 0.75 to 0.95 $cm^3/g$.

The total volume of micropores and mesopores in the porous particles may also be in the range from 0.4 to 0.75 $cm^3/g$, or from 0.4 to 0.7 $cm^3/g$, or from 0.4 to 0.65 $cm^3/g$, 0.45 to 0.75 $cm^3/g$, or from 0.45 to 0.7 $cm^3/g$, or from 0.45 to 0.65 $cm^3/g$, or from 0.45 to 0.6 $cm^3/g$. The total volume of micropores and mesopores in the porous particles may also be in the range from 0.6 to 2 $cm^3/g$, or from 0.6 to 1.8 $cm^3/g$, or from 0.7 to 1.8 $cm^3/g$, or from 0.7 to 1.6 $cm^3/g$, or from 0.8 to 1.6 $cm^3/g$, or from 0.8 to 1.5 $cm^3/g$, or from 0.8 to 1.4 $cm^3/g$, or from 0.9 to 1.5 $cm^3/g$, or from 0.9 to 1.4 $cm^3/g$, or from 1 to 1.4 $cm^3/g$.

The general term "$PD_n$ pore diameter" refers herein to the volume-based nth percentile pore diameter, based on the total volume of micropores and mesopores. For instance, the term "$PD_{50}$ pore diameter" as used herein refers to the pore diameter below which 50% of the total micropore and mesopore volume is found.

The $PD_{50}$ pore diameter of the porous particles is preferably no more than 30 nm, and optionally no more than 25 nm, or no more than 20 nm, or no more than 15 nm, or no more than 12 nm. More preferably, the $PD_{50}$ pore diameter of the porous particles is no more than 10 nm, or no more than 8 nm, or no more than 6 nm, or no more than 5 nm, or no more than 4 nm, or no more than 3 nm, or no more than 2.5 nm, or no more than 2 nm, or no more than 1.5 nm. The term "$PD_{50}$ pore diameter" as used herein refers to the volume-based median pore diameter, based on the total volume of micropores and mesopores. Therefore, in accordance with the invention, at least 50% of the total volume of micropores and mesopores is preferably in the form of pores having a diameter of less than 30 nm.

The $PD_{30}$ pore diameter of the porous particles may be no more than 25 nm, or no more than 20 nm, or no more than 15 nm, or no more than 12 nm, or no more than 10 nm, or no more than 8 nm, or no more than 6 nm, or no more than 5

nm, or no more than 4 nm, or no more than 3 nm, or no more than 2.5 nm, or no more than 2 nm, or no more than 1 nm.

The $PD_{90}$ pore diameter of the porous particles may be no more than 35 nm, or no more than 30 nm, or no more than 25 nm, or no more than 20 nm, or no more than 15 nm, or no more than 12 nm, or no more than 10 nm, or no more than 8 nm, or no more than 6 nm, or no more than 5 nm, or no more than 4 nm, or no more than 3 nm, or no more than 2.5 nm, or no more than 2 nm. Preferably, the $PD_{90}$ pore diameter of the porous particles is at least 2.5 nm, or at least 3 nm, or at least 3.5 nm, or at least 4 nm. For example, the $PD_{90}$ pore diameter of the porous particles is preferably in the range from 2.5 to 20 nm, or from 3 to 15 nm, or from 3.5 to 10 nm, or from 4 to 8 nm.

The $PD_{10}$ pore diameter of the porous particles may be no more than no more than 10 nm, or no more than 9 nm, or no more than 8 nm, or no more than 7 nm, or no more than 6 nm, or no more than 5 nm, or no more than 4 nm, or no more than 3 nm, or no more than 2.5 nm, or no more than 2 nm, or no more than 1.5 nm, or no more than 1 nm. Preferably, the $PD_{10}$ pore diameter of the porous particles is at least 0.3 nm, or at least 0.4 nm, or at least 0.5 nm. For example, the $PD_{10}$ pore diameter of the porous particles is preferably in the range from 0.3 to 10 nm, or from 0.3 to 5 nm, or from 0.3 to 1 nm, or from 0.4 to 1 nm, or from 0.5 to 1 nm.

For the avoidance of doubt, any macropore volume (pore diameter greater than 50 nm) is not taken into account for the purpose of determining $PD_n$ values.

The volumetric ratio of micropores to mesopores in the porous particles may range in principle from 100:0 to 0:100. Preferably, the volumetric ratio of micropores to mesopores is from 90:10 to 55:45, or from 90:10 to 60:40, or from 85:15 to 65:35.

The pore size distribution of the porous particles may be monomodal, bimodal or multimodal. As used herein, the term "pore size distribution" relates to the distribution of pore size relative to the cumulative total internal pore volume of the porous particles. A bimodal or multimodal pore size distribution may be preferred since close proximity between micropores and pores of larger diameter provides the advantage of efficient ionic transport through the porous network to the electroactive material.

The total volume of micropores and mesopores and the pore size distribution of micropores and mesopores are determined using nitrogen gas adsorption at 77 K down to a relative pressure $p/p_0$ of $10^{-6}$ using quenched solid density functional theory (QSDFT) in accordance with standard methodology as set out in ISO 15901-2 and ISO 15901-3. Nitrogen gas adsorption is a technique that characterizes the porosity and pore diameter distributions of a material by allowing a gas to condense in the pores of a solid. As pressure increases, the gas condenses first in the pores of smallest diameter and the pressure is increased until a saturation point is reached at which all of the pores are filled with liquid. The nitrogen gas pressure is then reduced incrementally, to allow the liquid to evaporate from the system. Analysis of the adsorption and desorption isotherms, and the hysteresis between them, allows the pore volume and pore size distribution to be determined. Suitable instruments for the measurement of pore volume and pore size distributions by nitrogen gas adsorption include the TriStar II and TriStar II Plus porosity analyzers, which are available from Micromeritics Instrument Corporation, USA, and the Autosorb IQ porosity analyzers, which are available from Quantachrome Instruments.

Nitrogen gas adsorption is effective for the measurement of pore volume and pore size distributions for pores having a diameter up to 50 nm, but is less reliable for pores of much larger diameter. For the purposes of the present invention, nitrogen adsorption is therefore used to determine pore volumes and pore size distributions only for pores having a diameter up to and including 50 nm (i.e. only for micropores and mesopores). $PD_{50}$ values are likewise determined relative to the total volume of micropores and mesopores only.

In view of the limitations of available analytical techniques it is not possible to measure pore volumes and pore size distributions across the entire range of micropores, mesopores and macropores using a single technique. In the case that the porous particles comprise macropores, the volume of pores having diameter in the range from greater than 50 nm and up to 100 nm may be measured by mercury porosimetry and is preferably no more than 0.3 $cm^3/g$, or no more than 0.2 $cm^3/g$, or no more than 0.1 $cm^3/g$, or no more than 0.05 $cm^3/g$. A small fraction of macropores may be useful to facilitate electrolyte access into the pore network, but the advantages of the invention are obtained substantially by accommodating electroactive material in micropores and smaller mesopores.

Any pore volume measured by mercury porosimetry at pore sizes of 50 nm or below is disregarded (as set out above, nitrogen adsorption is used to characterize the mesopores and micropores). Pore volume measured by mercury porosimetry above 100 nm is assumed for the purposes of the invention to be inter-particle porosity and is also disregarded.

Mercury porosimetry is a technique that characterizes the porosity and pore diameter distributions of a material by applying varying levels of pressure to a sample of the material immersed in mercury. The pressure required to intrude mercury into the pores of the sample is inversely proportional to the size of the pores. Values obtained by mercury porosimetry as reported herein are obtained in accordance with ASTM UOP578-11, with the surface tension $\gamma$ taken to be 480 mN/m and the contact angle $\varphi$ taken to be 140° for mercury at room temperature. The density of mercury is taken to be 13.5462 $g/cm^3$ at room temperature. A number of high precision mercury porosimetry instruments are commercially available, such as the AutoPore IV series of automated mercury porosimeters available from Micromeritics Instrument Corporation, USA. For a complete review of mercury porosimetry reference may be made to P.A. Webb and C. Orr in

"Analytical Methods in Fine Particle Technology, 1997, Micromeritics Instrument Corporation, ISBN 0-9656783-0.

It will be appreciated that intrusion techniques such as gas adsorption and mercury porosimetry are effective only to determine the pore volume of pores that are accessible to nitrogen or to mercury from the exterior of the porous particles. Porosity values specified herein shall be understood as referring to the volume of open pores, i.e. pores that are accessible to a fluid from the exterior of the porous particles. Fully enclosed pores which cannot be identified by nitrogen adsorption or mercury porosimetry shall not be taken into account herein when determining porosity values. Likewise, any pore volume located in pores that are so small as to be below the limit of detection by nitrogen adsorption is not taken into account.

The term "particle diameter" as used herein refers to the equivalent spherical diameter (esd), i.e. the diameter of a sphere having the same volume as a given particle, wherein the particle volume is understood to include the volume of any intra-particle pores. The terms "$D_{50}$" and "$D_{50}$ particle diameter" as used herein refer to the volume-based median particle diameter, i.e. the diameter below which 50% by volume of the particle population is found. The terms "$D_{10}$" and "$D_{10}$ particle diameter" as used herein refer to the 10th percentile volume-based median particle diameter, i.e. the diameter below which 10% by volume of the particle population is found. The terms "$D_{90}$" and "$D_{90}$ particle diameter" as used herein refer to the 90th percentile volume-based median particle diameter, i.e. the diameter below which 90% by volume of the particle population is found.

Particle diameters and particle size distributions can be determined by standard laser diffraction techniques in accordance with ISO 13320:2009. Laser diffraction relies on the principle that a particle will scatter light at an angle that varies depending on the size the particle and a collection of particles will produce a pattern of scattered light defined by intensity and angle that can be correlated to a particle size distribution. A number of laser diffraction instruments are commercially available for the rapid and reliable determination of particle size distributions. Unless stated otherwise, particle size distribution measurements as specified or reported herein are as measured by the conventional Malvern Mastersizer™ 3000 particle size analyzer from Malvern Instruments™. The Malvern Mastersizer™ 3000 particle size analyzer operates by projecting a helium-neon gas laser beam through a transparent cell containing the particles of interest suspended in an aqueous solution. Light rays which strike the particles are scattered through angles which are inversely proportional to the particle size and a photodetector array measures the intensity of light at several predetermined angles and the measured intensities at different angles are processed by a computer using standard theoretical principles to determine the particle size distribution. Laser diffraction values as reported herein are obtained using a wet dispersion of the particles in 2-propanol with a 5 vol% addition of the surfactant SPAN™-40 (sorbitan monopalmitate). The particle refractive index is taken to be 2.68 for porous particles and 3.50 for composite particles and the dispersant index is taken to be 1.378. Particle size distributions are calculated using the Mie scattering model.

In general, the porous particles have a $D_{50}$ particle diameter in the range from 0.5 to 200 μm. Optionally, the $D_{50}$ particle diameter of the porous particles may be at least 1 μm, or at least 1.5 μm, or at least 2 μm, or at least 2.5 μm, or at least 3 μm, or at least 4 μm, or at least 5 μm. Optionally the $D_{50}$ particle diameter of the porous particles may be no more than 150 μm , or no more than 100 μm, or no more than 70 μm, or no more than 50 μm, or no more than 40 μm, or no more than 30 μm, or no more than 25 μm, or no more than 20 μm, or no more than 18 μm, or no more than 15 μm, or no more than 12 μm, or no more than 10 μm, or no more than 8 μm.

For instance, the porous particles may have a $D_{50}$ particle diameter in the range from 0.5 to 150 μm, or from 0.5 to 100 μm, or from 0.5 to 50 μm, or from 0.5 to 30 μm, or from 1 to 25 μm, or from 1 to 20 μm, or from 2 to 25 μm, or from 2 to 20 μm, or from 2 to 18 μm, or from 2 to 15 μm, or from 2 to 12 μm, or from 2.5 to 15 μm, or from 2.5 to 12 μm, or from 2 to 10 μm, or from 3 to 20 μm, or from 3 to 18 μm, or from 3 to 15 μm, or from 4 to 18 μm, or from 4 to 15 μm, or from 4 to 12 μm, or from 5 to 15 μm, or from 5 to 12 μm or from 5 to 10 μm, or from 5 to 8 μm. Particles within these size ranges and having porosity and a pore diameter distribution as set out herein are ideally suited for the preparation of composite particles for use in anodes for metal-ion batteries by a CVI process.

The $D_{10}$ particle diameter of the porous particles is preferably at least 0.2 μm, or at least 0.5 μm, or at least 0.8 μm, or at least 1 μm, or at least 1.5 μm, or at least 2 μm. By maintaining the $D_{10}$ particle diameter at 0.2 μm or more, the potential for undesirable agglomeration of sub-micron sized particles is reduced, and improved dispersibility of the composite particles formed.

The $D_{90}$ particle diameter of the porous particles is preferably no more than 300 μm, or no more than 250 μm, or no more than 200 μm, or no more than 150 μm, or no more than 100 μm, or no more than 80 μm, or no more than 60 μm, or no more than 40 μm, or no more than 30 μm, or no more than 25 μm, or no more than 20 μm.

The porous particles preferably have a narrow size distribution span. For instance, the particle size distribution span (defined as $(D_{90}-D_{10})/D_{50}$) is preferably 5 or less, more preferably 4 or less, more preferably 3 or less, more preferably 2 or less, and most preferably 1.5 or less. By maintaining a narrow size distribution span, efficient packing of the particles into dense powder beds is more readily achievable.

The porous particles may have an average sphericity (as defined herein) of more than 0.5. Preferably they have an average sphericity of at least 0.55, or at least 0.6, or at least 0.65, or at least 0.7, or at least 0.75, or at least 0.8, or at least 0.85. Preferably, the porous particles have an average sphericity of at least 0.90, or at least 0.92, or at least 0.93, or at least 0.94, or at least 0.95. Spherical particles are believed to aid uniformity of deposition and facilitate denser packing both in

the batch pressure reactor and of the final product when incorporated into electrodes.

It is possible to obtain highly accurate two-dimensional projections of micron scale particles by scanning electron microscopy (SEM) or by dynamic image analysis, in which a digital camera is used to record the shadow projected by a particle. The term "sphericity" as used herein shall be understood as the ratio of the area of the particle projection (obtained from such imaging techniques) to the area of a circle, wherein the particle projection and circle have identical circumference. Thus, for an individual particle, the sphericity S may be defined as:

$$S = \frac{4 \cdot \pi \cdot A_m}{(C_m)^2}$$

wherein $A_m$ is the measured area of the particle projection and $C_m$ is the measured circumference of the particle projection. The average sphericity $S_{av}$ of a population of particles as used herein is defined as:

$$S_{av} = \frac{1}{n} \sum_{i=1}^{n} \left[ \frac{4 \cdot \pi \cdot A_m}{(C_m)^2} \right]$$

wherein n represents the number of particles in the population. The average sphericity for a population of particles is preferably calculated from the two-dimensional projections of at least 50 particles.

The porous particles preferably have a BET surface area of at least 100 $m^2/g$, or at least 500 $m^2/g$, or at least 750 $m^2/g$, or at least 1,000 $m^2/g$, or at least 1,250 $m^2/g$, or at least 1,500 $m^2/g$. The term "BET surface area" as used herein should be taken to refer to the surface area per unit mass calculated from a measurement of the physical adsorption of gas molecules on a solid surface, using the Brunauer-Emmett-Teller theory, in accordance with ISO 9277. Preferably, the BET surface area of the porous particles is no more than 4,000 $m^2/g$, or no more than 3,500 $m^2/g$, or no more than 3,250 $m^2/g$, or no more than 3,000 $m^2/g$ or no more than 2,500 $m^2/g$, or no more than 2,000 $m^2/g$. For example, the porous particles may have a BET surface area in the range from 100 $m^2/g$ to 4,000 $m^2/g$, or from 500 $m^2/g$ to 4,000 $m^2/g$, or from 750 $m^2/g$ to 3,500 $m^2/g$, or from 1,000 $m^2/g$ to 3,250 $m^2/g$, or from 1,000 $m^2/g$ to 3,000 $m^2/g$, or from 1,000 $m^2/g$ to 2,500 $m^2/g$, or from 1,000 $m^2/g$ to 2,000 $m^2/g$.

The porous particles preferably have a particle density of at least 0.35 and preferably less than 3 $g/cm^3$, more preferably less than 2 $g/cm^3$, more preferably less than 1.5 $g/cm^3$, most preferably from 0.35 to 1.2 $g/cm^3$. As used herein, the term "particle density" refers to "apparent particle density" as measured by mercury porosimetry (i.e. the mass of a particle divided by the particle volume wherein the particle volume is taken to be the sum of the volume of solid material and any closed or blind pores (a "blind pore" is pore that is too small to be measured by mercury porosimetry). Preferably, the porous particles have particle density of at least 0.4 $g/cm^3$, or at least 0.45 $g/cm^3$, or at least 0.5 $g/cm^3$, or at least 0.55 $g/cm^3$, or at least 0.6 $g/cm^3$, or at least 0.65 $g/cm^3$, or at least 0.7 $g/cm^3$. Preferably, the porous particles have particle density of no more than 1.15 $g/cm^3$, or no more than 1.1 $g/cm^3$, or no more than 1.05 $g/cm^3$, or no more than 1 $g/cm^3$, or no more than 0.95 $g/cm^3$, or no more than 0.9 $g/cm^3$.

Preferably the porous particles have:

(i) a total pore volume of micropores and mesopores as measured by nitrogen gas adsorption in the range from 0.4 to 2.2 $cm^3/g$;
(ii) a $PD_{50}$ pore diameter of no more than 20 nm, preferably a $PD_{90}$ pore diameter of no more than 30 nm, preferably a $PD_{30}$ pore diameter of no more than 15 nm; and
(iii) a $D_{50}$ particle diameter in the range from 0.5 to 30 $\mu m$.

More preferably the porous particles have:

(i) a total pore volume of micropores and mesopores as measured by nitrogen gas adsorption in the range from 0.6 to 1.8 $cm^3/g$;
(ii) a $PD_{50}$ pore diameter of no more than 10 nm, preferably a $PD_{90}$ pore diameter of no more than 20 nm, preferably a $PD_{30}$ pore diameter of no more than 8 nm; and
(iii) a $D_{50}$ particle diameter in the range from 1 to 25 $\mu m$.

More preferably the porous particles have:

(i) a total pore volume of micropores and mesopores as measured by nitrogen gas adsorption in the range from 0.7 to 1.6 $cm^3/g$;

(ii) a $PD_{50}$ pore diameter of no more than 10 nm, preferably a $PD_{90}$ pore diameter of no more than 20 nm, preferably a $PD_{30}$ pore diameter of no more than 8 nm; and
(iii) a $D_{50}$ particle diameter in the range from 1 to 20 μm.

More preferably the porous particles have:

(i) a total pore volume of micropores and mesopores as measured by nitrogen gas adsorption in the range from 0.7 to 1.5 $cm^3/g$;
(ii) a $PD_{50}$ pore diameter of no more than 5 nm, preferably a $PD_{90}$ pore diameter of no more than 10 nm, preferably a $PD_{30}$ pore diameter of no more than 3 nm; and
(iii) a $D_{50}$ particle diameter in the range from 2 to 20 μm.

More preferably the porous particles have:

(i) a total pore volume of micropores and mesopores as measured by nitrogen gas adsorption in the range from 0.7 to 1.4 $cm^3/g$;
(ii) a $PD_{50}$ pore diameter of no more than 5 nm, preferably a $PD_{90}$ pore diameter of no more than 10 nm, preferably a $PD_{30}$ pore diameter of no more than 3 nm; and
(iii) a $D_{50}$ particle diameter in the range from 2 to 20 μm.

More preferably the porous particles have:

(i) a total pore volume of micropores and mesopores as measured by nitrogen gas adsorption in the range from 0.7 to 1.4 $cm^3/g$;
(ii) a $PD_{50}$ pore diameter of no more than 5 nm, preferably a $PD_{90}$ pore diameter of no more than 10 nm, preferably a $PD_{30}$ pore diameter of no more than 3 nm; and
(iii) a $D_{50}$ particle diameter in the range from 2 to 18 μm.

More preferably the porous particles have:

(i) a total pore volume of micropores and mesopores as measured by nitrogen gas adsorption in the range from 0.7 to 1.4 $cm^3/g$;
(ii) a $PD_{50}$ pore diameter of no more than 2 nm, preferably a $PD_{90}$ pore diameter of no more than 5 nm, preferably a $PD_{30}$ pore diameter of no more than 1 nm; and
(iii) a $D_{50}$ particle diameter in the range from 2 to 15 μm.

The electroactive materials deposited in steps (b) and (d) may be the same or different, and may optionally be independently selected from silicon, tin, germanium, aluminium and mixtures and alloys thereof. A preferred electroactive material is silicon. Preferably, the electroactive material deposited in at least one of steps (b) and (d) is silicon. More preferably, both the electroactive material deposited in each one of steps (b) and (d) is silicon.

Suitable precursors of silicon include silane ($SiH_4$), disilane ($Si_2H_6$), trisilane ($Si_3H_8$), tetrasilane ($Si_4H_{10}$), methylsilane ($CH_3SiH_3$), dimethylsilane ($(CH_3)_2SiH_2$), or chlorosilanes such as trichlorosilane ($HSiCl_3$) or methylchlorosilanes such as methyltrichlorosilane ($CH_3SiCl_3$) or dimethyldichlorosilane ($(CH_3)_2SiCl_2$). A preferred precursor of silicon is silane.

Suitable precursors of tin include bis[bis(trimethylsilyl)amino]tin(II) ($[[(CH_3)_3Si]_2N]_2Sn$), tetraallyltin ($(H_2C{=}CHCH_2)_4Sn$), tetrakis(diethylamido)tin(IV) ($[(C_2H_5)_2N]_4Sn$), tetrakis(dimethylamido)tin(IV) ($[(CH_3)_2N]_4Sn$), tetramethyltin ($Sn(CH_3)_4$), tetravinyltin ($Sn(CH{=}CH_2)_4$), tin(II) acetylacetonate ($C_{10}H_{14}O_4Sn$), trimethyl(phenylethynyl)tin ($C_6H_5C{\equiv}CSn(CH_3)_3$), and trimethyl(phenyl)tin ($C_6H_5Sn(CH_3)_3$). A preferred precursor of tin is tetramethyltin.

Suitable precursors of aluminium include aluminium tris(2,2,6,6-tetramethyl-3,5-heptanedionate) ($Al(OCC(CH_3)_3CHCOC(CH_3)_3)_3$), trimethylaluminium ($(CH_3)_3Al$), and tris(dimethylamido)aluminium(III) ($Al(N(CH_3)_2)_3$). A preferred precursor of aluminium is trimethylaluminium.

Suitable precursors of germanium include germane ($GeH_4$), hexamethyldigermanium ($(CH_3)_3GeGe(CH_3)_3$), tetramethylgermanium ($(CH_3)_4Ge$), tributylgermanium hydride ($[CH_3(CH_2)_3]_3GeH$), triethylgermanium hydride ($(C_2H_5)_3GeH$), and triphenylgermanium hydride ($(C_6H_5)_3GeH$). A preferred precursor of germanium is germane.

In the case that the precursor is a chlorinated compound, such as a chlorosilane, the precursor is used in admixture with hydrogen gas, preferably in at least a 1:1 atomic ratio of hydrogen to chlorine.

Optionally, the precursor is free of chlorine. Free of chlorine means that the precursor contains less than 1 wt%, preferably less than 0.1wt%, preferably less than 0.01 wt% of chlorine-containing compounds.

The precursors in steps (b) and (d) may be used either in pure form (or substantially pure form) or as a diluted mixture with an inert carrier gas, such as nitrogen or argon. When in a diluted mixture with an inert carrier gas, the precursor is preferably used in an amount in the range from 1 to 95 vol%, or 1 to 85 vol%, or 1 to 70 vol%, or 1 to 50 vol%, or 2 to 40 vol%, or 5 to 30 vol%, or from 5 to 25 vol% based on the total gaseous volume of the precursor and an inert carrier gas. The presence of oxygen should be minimized to prevent undesired oxidation of the deposited electroactive material, in accordance with conventional procedures for working in an inert atmosphere. Preferably, the oxygen content is less than 0.01 vol%, more preferably less than 0.001 vol% based on the total volume of gas used in steps (b) and (d).

The temperature in steps (b) and (d) is any temperature that is effective to decompose the precursor to form the electroactive material. Preferably, the temperature in steps (b) and (d) is independently in the range from 300 to 800 °C, or from 350 to 800 °C, or 380 to 700 °C, or from 380 to 650 °C, or from 380 to 600 °C, or from 380 to 550 °C, or from 380 to 500 °C, or from 400 to 450 °C, or from 450 to 500 °C, or from 350 to 500 °C, or from 350 to 450 °C, or from 380 to 450 °C. More preferably, the temperature in each of steps (b) and (d) is independently in the range of 380-500 °C, preferably 380-450 °C.

The pressure in at least one of steps (b) and (d) is maintained at less than 200 kPa. Preferably, the pressure in at least one of steps (b) and (d) is maintained at or below 150 kPa, or at or below 120 kPa, or at or below 110 kPa, or at or below 100 kPa, or at or below 90 kPa, or at or below 80 kPa, or at or below 70 kPa, or at or below 60 kPa, or at or below 50 kPa.

Preferably, the pressure in at least step (b) is maintained at less than 200 kPa. Preferably, the pressure in at least step (b) is maintained at or below 150 kPa, or at or below 120 kPa, or at or below 110 kPa, or at or below 100 kPa, or at or below 90 kPa, or at or below 80 kPa, or at or below 70 kPa, or at or below 60 kPa, or at or below 50 kPa.

Optionally, the pressure in both of steps (b) and (d) may be maintained at less than 200 kPa. Optionally, the pressure in both of steps (b) and (d) may be maintained at or below 150 kPa, or at or below 120 kPa, or at or below 110 kPa, or at or below 100 kPa, or at or below 90 kPa, or at or below 80 kPa, or at or below 70 kPa, or at or below 60 kPa, or at or below 50 kPa.

The pressure in step (b) may be lower than the pressure in step (d). For example, the pressure in step (b) may be maintained at less than 200 kPa while the pressure in step (d) is above 200 kPa, or the pressure in step (b) may be maintained at less than 150 kPa while the pressure in step (d) is above 150 kPa, or the pressure in step (b) may be maintained at less than 120 kPa while the pressure in step (d) is above 120 kPa, or the pressure in step (b) may be maintained at less than 110 kPa while the pressure in step (d) is above 110 kPa, or the pressure in step (b) may be maintained at less than 100 kPa while the pressure in step (d) is above 100 kPa.

Reduced pressure in step (b) as compared to step (d) may be advantageous in circumstances where additional control over the deposition is required at an early stage of deposition, particularly when infiltrating highly microporous particles. As set out above, carrying out at step (b) at low pressure results in increased diffusivity of the precursor of the electroactive material, allowing it to access micropores and/or the smallest mesopores prior to thermal decomposition.

Alternatively, the pressure in step (d) may be lower than the pressure in step (b). For example, the pressure in step (b) may be above 200 kPa while the pressure in step (d) is maintained at less than 200 kPa, or the pressure in step (b) may be above 150 kPa while the pressure in step (d) is maintained at less than 150 kPa, or the pressure in step (b) may be above 120 kPa while the pressure in step (d) is maintained at less than 120 kPa, or the pressure in step (b) may be above 110 kPa while the pressure in step (d) is maintained at less than 110 kPa, or the pressure in step (b) may be above 100 kPa while the pressure in step (d) is maintained at less than 100 kPa.

Reduced pressure in step (d) as compared to step (b) may be advantageous in circumstances where additional control over the deposition is required at a late stage of deposition. For instance, in the case where the electroactive material occupies a high proportion of the pore volume of the porous particles, additional control may be required at a late stage to ensure that the precursor gas infiltrates the residual pore volume therefore ensuring that the electroactive material deposits preferentially within the internal pore volume and not onto the exterior surfaces of the porous particles.

References to the pressure in any step of the claimed process refer to the absolute pressure in the reaction zone, which may comprise any suitable form of reactor vessel.

The deposition of electroactive materials by CVI results in the elimination of by-products, particularly by-product gases such as hydrogen. Step (c) preferably comprises at least the separation of by-products from the intermediate particles formed in step (b). Separation of by-products from the intermediate particles formed in step (b) may be effected by flushing the reactor with an inert gas and/or by evacuating the reactor by reducing the pressure. For example, the separation of by-products from the intermediate particles formed in step (b) may be effected by evacuating the reactor to a pressure of less than 100 kPa, or less than 80 kPa, or less than 60 kPa, or less than 40 kPa, or less than 20 kPa, or less than 10 kPa, or less than 5 kPa, or less than 2 kPa, or less than 1 kPa. Evacuating the reactor to low pressure may be effective not only to remove by-products in the gas phase, but also to desorb any by-products that may be adsorbed onto the surfaces of the deposited electroactive material.

As discussed above, step (c) may optionally comprise a step of forming a modifier material on the surface of the electroactive material deposited in step (b).

The modifier material formed in step (c) may optionally be a passivation layer formed on the surface of the electroactive material deposited in step (b). Accordingly, step (c) may further comprise contacting the intermediate

particles from step (b) with a passivating agent. As defined herein, a passivating agent is a compound of mixture of compounds which is able to react with the surface of the electroactive material deposited in step (b) to form a modified surface.

The passivation layer may be a native oxide layer. A native oxide layer may be formed, for example, by exposing the surface of the electroactive material to a passivating agent selected from air or another oxygen containing gas. In the case that the first electroactive material is silicon, the passivation layer may comprise a silicon oxide of the formula $SiO_x$, wherein $0 < x \leq 2$. The silicon oxide is preferably amorphous silicon oxide. The formation of a native oxide layer is exothermic and therefore requires careful process control to prevent overheating or even combustion of the particulate material. In the case that the modifier material formed in step (c) is a native oxide layer, step (c) may comprise cooling the material formed in step (b) to a temperature below 300 °C, preferably below 200 °C, optionally below 100 °C, prior to contacting the surface of the electroactive material domains with the oxygen containing gas.

The passivation layer may be a nitride layer that is formed, for example, by exposing the surface of the electroactive material to a passivating agent selected from ammonia or another nitrogen containing molecule prior to deposition of the second electroactive material layer. In the case that the electroactive material is silicon, the passivation layer may comprise a silicon nitride of the formula $SiN_x$, wherein $0 < x \leq 4/3$. The silicon nitride is preferably amorphous silicon nitride. A nitride layer may be formed by contacting the surface of the electroactive material domains with ammonia at a temperature in the range from 200-700 °C, preferably from 400-700 °C, more preferably from 400-600 °C. The temperature may then be increased if necessary into the range of 500 to 1,000 °C to form a nitride surface (e.g. a silicon nitride surface of the formula SiNx, wherein $x \leq 4/3$). For example, where ammonia is used, step (c) may be carried out at the same or similar temperature as is used to deposit the electroactive material domains in step (b). Nitride passivation may be preferred to oxide passivation. As sub-stoichiometric nitrides (such as $SiN_x$, wherein $0 < x \leq 4/3$) are conductive, nitride interlayers function as a conductive network that allows for faster charging and discharging of the electroactive material. Nitride modifier material domains are also thought to improve capacity retention. Phosphine may also be used as a passivating agent, as a phosphorus analogue of ammonia.

The passivation layer may be an oxynitride layer that is formed, for example, by exposing the surface of the first electroactive material layer to a passivating agent comprising ammonia (or another nitrogen containing molecule) and oxygen gas prior to deposition of the second electroactive material layer. In the case that the first electroactive material layer is silicon, the first interlayer material may comprise a silicon oxynitride of the formula $SiO_xN_y$, wherein $0 < x < 2$, $0 < y < 4/3$, and $0 < (2x+3y) \leq 4$). The silicon nitride is preferably amorphous silicon oxynitride.

The passivation layer may be a carbide layer. In the case that the first electroactive material layer is silicon, the first interlayer may comprise a silicon carbide of the formula $SiC_x$, wherein $0 < x \leq 1$. The silicon carbide is preferably amorphous silicon carbide. A carbide layer may be formed by contacting the surface of the first electroactive material with a passivating agent selected from carbon containing precursors, e.g. methane or ethylene at elevated temperatures, e.g. in the range from 250 to 700 °C. At lower temperatures, covalent bonds are formed between the surface of the electroactive material and the carbon-containing precursors, which are the converted to a monolayer of crystalline silicon carbide as the temperature is increased. In the case that the electroactive material domains comprise silicon, the modifier material domains may comprise a silicon carbide of the formula SiCx, wherein $0 < x \leq 1$.

The passivation layer may comprise an organic moiety covalently bonded to at least a portion of the surface of the electroactive material. For example, the modifier material domains may comprise a carbon-containing organic moiety covalently bonded to at least a portion of the surface of the electroactive material domains. For example, the modifier material domains may comprise a hydrocarbyl group covalently bonded to the surface of the electroactive material domains.

Suitable passivating agents for forming a passivation layer comprising an organic moiety covalently bonded to at least a portion of the surface of the electroactive material include compounds comprising an alkene, alkyne or carbonyl functional group, more preferably a terminal alkene, terminal alkyne, aldehyde or ketone group.

Preferred passivating agents include one or more compounds of the formulae:

(i) $R^1$-CH=CH-$R^1$;
(ii) $R^1$-C≡C-$R^1$; and
(iii) O=C$R^1R^1$;

wherein each $R^1$ independently represents H or an unsubstituted or substituted aliphatic or aromatic hydrocarbyl group having from 1 to 20 carbon atoms, or wherein two $R^1$ groups form an unsubstituted or substituted ring structure comprising from 3 to 8 carbon atoms in the ring.

Particularly preferred passivating agents include one or more compounds of the formulae:

(i) $CH_2$=CH-$R^1$; and
(ii) HC≡C-$R^1$;

wherein $R^1$ is as defined above. Preferably, $R^1$ is unsubstituted.

Examples of suitable passivating agents include ethylene, propylene, 1-butene, butadiene, 1-pentene, 1,4-pentadiene, 1-hexene, 1-octene, styrene, divinylbenzene, acetylene, phenylacetylene, norbornene, norbornadiene and bicyclo[2.2.2]oct-2-ene. Optionally, mixtures of different passivating agents may also be used.

It is believed that passivating agents comprising an alkene, alkyne or carbonyl group undergo an insertion reaction with M-H groups at the surface of the electroactive material (where M represents an atom of the electroactive material) to form a covalently passivated surface which is resistant to oxidation by air. When silicon is the electroactive material, the passivation reaction between the silicon surface and the passivating agent may be understood as a form of hydrosilylation, as shown schematically below.

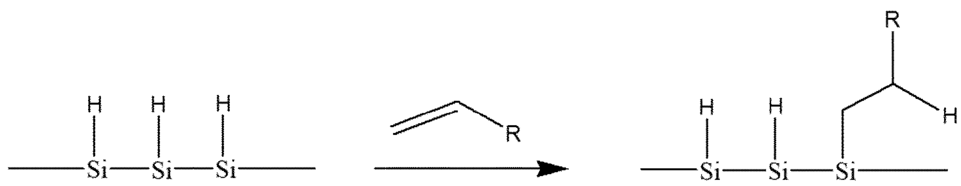

Replacing hydride terminations at the surface of the electroactive material domains with covalently bonded organic modifier material domains such as a carbon-containing organic moiety is advantageous because hydride terminations can decompose to produce hydrogen gas which can be detrimental to topography of electrodes. Further, Si-C bonding is thought to improve conductivity.

Other suitable passivating agents include compounds including an active hydrogen atom bonded to oxygen, nitrogen, sulphur or phosphorus. For example, the passivating agent may be an alcohol, amine, thiol or phosphine. Reaction of the group -XH with hydride groups at the surface of the electroactive material is understood to result in elimination of $H_2$ and the formation of a direct bond between X and the electroactive material surface.

Suitable passivating agents in this category include compounds of the formula

(iv) $HX-R^2$, and
(v) $HX-C(O)-R^1$,

wherein X represents O, S, $NR^1$ or $PR^1$; each $R^1$ is independently as defined above; and $R^2$ represents an unsubstituted or substituted aliphatic or aromatic hydrocarbyl group having from 1 to 20 carbon atoms, or $R^1$ and $R^2$ together form an unsubstituted or substituted ring structure comprising from 3 to 8 carbon atoms in the ring.

Preferably X represents O or NH.

Preferably $R^2$ represents an optionally substituted aliphatic or aromatic group having from 2 to 10 carbon atoms. Amine groups may also be incorporated into a 4-10 membered aliphatic or aromatic ring structure, as in pyrrolidine, pyrrole, imidazole, piperazine, indole, or purine.

Contacting of the electroactive material with the passivating agent in step (c) may be carried out at a temperature in the range of 25 to 700 °C, preferably at a temperature in the range of from 50 to 500 °C, more preferably from 100 to 300 °C.

The modifier material formed in step (c) may optionally comprise a pyrolytic carbon material deposited onto the surface of the electroactive material by thermal decomposition of a carbon-containing precursor, i.e. by a chemical vapour infiltration (CVI) method. Deposition of a pyrolytic carbon material in step (c) may be advantageous as it forms a conductive network between electroactive material domains which may facilitate electron transport within the composite particles. Step (c) may therefore comprise contacting the intermediate particles from step (b) with a carbon-containing precursor, preferably a hydrocarbon, at a temperature effective to cause deposition of a pyrolytic carbon material in the pores of the intermediate particles.

Suitable hydrocarbons include polycyclic hydrocarbons comprising from 10 to 25 carbon atoms and optionally from 1 to 3 heteroatoms, optionally wherein the polyaromatic hydrocarbon is selected from naphthalene, substituted naphthalenes such as dihydroxynaphthalene, anthracene, tetracene, pentacene, fluorene, acenapthene, phenanthrene, fluoranthrene, pyrene, chrysene, perylene, coronene, fluorenone, anthraquinone, anthrone and alkyl-substituted derivatives thereof. Suitable pyrolytic carbon precursors also include bicyclic monoterpenoids, optionally wherein the bicyclic monoterpenoid is selected from camphor, borneol, eucalyptol, camphene, careen, sabinene, thujene and pinene. Further suitable pyrolytic carbon precursors include $C_2$-$C_{10}$ hydrocarbons, optionally wherein the hydrocarbons are selected from alkanes, alkenes, alkynes, cycloalkanes, cycloalkenes, and arenes, for example methane, ethylene, propylene, limonene, styrene, cyclohexane, cyclohexene, $\alpha$-terpinene and acetylene. Other suitable pyrolytic carbon precursors include phthalocyanine, sucrose, starches, graphene oxide, reduced graphene oxide, pyrenes, perhydropyrene, triphenylene, tetracene, benzopyrene, perylenes, coronene, and chrysene. A preferred carbon precursor is acetylene.

A suitable temperature for the deposition of a pyrolytic carbon material in step (c) is in the range from 300 to 800 °C, or from 400 to 700 °C. For example, the temperature may be no more than 680 °C or no more than 660 °C, or no more than 640 °C or no more than 620 °C, or no more than 600 °C, or no more than 580 °C, or no more than 560 °C, or no more than 540 °C, or no more than 520 °C, or no more than 500 °C. The minimum temperature will depend on the type of carbon precursor that is used. Preferably, the temperature is at least 300 °C, or at least 350 °C, or at least 400 °C, or at least 450 °C, or at least 500 °C.

The carbon-containing precursors used in step (c) may be used in pure form, or diluted mixture with an inert carrier gas, such as nitrogen or argon. For instance, the carbon-containing precursor may be used in an amount in the range from 0.1 to 100 vol%, or 0.5 to 20 vol%, or 1 to 10 vol%, or 1 to 5 vol% based on the total volume of the precursor and the inert carrier gas. The presence of oxygen should be minimised to prevent undesired oxidation of the deposited electroactive material. Preferably, the oxygen content is less than 0.01 vol%, more preferably less than 0.001 vol% based on the total volume of gas.

In the case that a pyrolytic carbon material is deposited in step (c), the same compound may function as both a passivating agent and the pyrolytic carbon precursor. For example, if styrene is selected as the pyrolytic carbon precursor, then it will also function as a passivating agent if the intermediate particles from step (b) are not exposed to oxygen prior to contact with styrene. In this case, passivation and deposition of the conductive carbon material in steps may be carried out simultaneously, for example at a temperature in the range of from 300-700 °C. Alternatively, passivation and deposition of the conductive carbon material may be carried out sequentially, with the same material as the passivating agent and the pyrolytic carbon precursor, but wherein the deposition of the pyrolytic carbon precursor is carried out at a higher temperature than the passivation. For example, passivation may be carried out at a temperature in the range of from 25 °C to less than 300 °C, and deposition of pyrolytic carbon may be carried out at a temperature in the range from 300-700 °C. These two steps may suitably be carried out sequentially by increasing the temperature while maintaining contact with the compound that functions as both a passivating agent and the pyrolytic carbon precursor. At lower temperatures (e.g. in the range of 25 °C to < 300 °C) passivation will be the primary process. As the temperature is increased (e.g. to 300-700 °C) the deposition of pyrolytic carbon will ensue.

Depending on the amount of electroactive material deposited in each step, the process of the invention may be operated as a multi-pass process in which steps (c) and (d) are repeated as many times as necessary to deposit the target amount of electroactive material. For example, steps (c) and (d) may be carried out from 2 to 15 times, giving a total of from 3 to 16 electroactive material depositions steps including step (b) and the repetitions of step (d).

When steps (c) and (d) are repeated, the requirement that the pressure in at least one of steps (b) and (d) is maintained at less than 200 kPa shall be interpreted as referring to step (b) or any one of the steps (d). Preferably the pressure in at least step (b) is maintained at less than 200 kPa.

Optionally, the pressure in more than one of step (b) and the repeated steps (d) may be maintained at less than 200 kPa. For example, the pressure in at least step (b) and at least one of the steps (d) may be maintained at less than 200 kPa. Optionally, the pressure in all of steps (b) and the repeated steps (d) may be maintained at less than 200 kPa.

When steps (c) and (d) are repeated, each instance of step (c) and (d) is independently as described above. For instance, each repetition of step (c) may comprise the formation of the same or a different modifier material, or no modifier material at all may optionally be formed in one or more steps. Likewise, the electroactive materials deposited in each repetition of step (d) may be the same or different, and may be the same or different again from the electroactive material deposited in step (b). Preferably, the electroactive material deposited in at least one of steps (b) and the repeated steps (d) is silicon. More preferably, the electroactive material deposited in each of steps (b) and the repeated steps (d) is silicon.

When steps (c) and (d) are repeated, the particles used in the repetition of step (c) are intermediate particles obtained from the preceding step (d). Accordingly, any references herein to "particles from step (b)" in the description of step (c) shall be interpreted "as particles from the preceding step (d)" in the case of any repetition of step (c).

A range of different electroactive material loadings in the composite particles may be obtained using the process of the invention. For example, the amount of electroactive material (e.g. silicon) in the composite particles may be in the range of from 5 to 85 wt% based on the total mass of the composite particles. Preferably, the amount of electroactive material in the composite particles is from 10 to 85 wt%, or from 15 to 85 wt%, or from 20 to 80 wt%, or from 25 to 80 wt%, or from 30 to 75 wt%, or from 35 to 75 wt%, or from 40 to 70 wt%, or from 45 to 65 wt% based on the total mass of the composite particles. The total electroactive material loading in the composite particles is the sum of the electroactive material deposited in steps (b) and (d) (including repetitions of step (d)).

The amount of electroactive material (e.g. silicon) in the composite particles is preferably selected such that at least 20% and up to 90% of the internal pore volume of the porous particles is occupied by the electroactive material following step (c). For example, the electroactive material may occupy from 20% to 80%, or from 25% to 75%, or from 30% to 70%, or from 35 to 65%, or from 40 to 60%, or from 45% to 55% of the internal pore volume of the porous particles. Within these preferred ranges, the remaining pore volume of the porous particles is effective to accommodate expansion of the electroactive material during charging and discharging, without a large excess pore volume which does not contribute to the volumetric capacity of the particulate particles. However, the amount of electroactive material is also not so high as to

impede effective lithiation due to inadequate metal-ion diffusion rates or due to inadequate expansion volume resulting in mechanical resistance to lithiation.

In the case that the electroactive material is silicon, the amount of silicon in the composite particles can be related to the available pore volume in the porous particles by the requirement that the mass ratio of silicon to the porous particles is in the range from $[0.5\times P^1$ to $1.9\times P^1] : 1$, wherein $P^1$ is a dimensionless quantity having the magnitude of the total pore volume of micropores and mesopores in the porous particles, as expressed in $cm^3/g$ (e.g. if the porous particles have a total volume of micropores and mesopores of 1.2 $cm^3/g$, then $P^1 = 1.2$). This relationship takes into account the density of silicon and the pore volume of the porous particles to define a weight ratio of silicon at which the pore volume is around 20% to 82% occupied.

The amount of electroactive materials in the composite particles can be determined by elemental analysis. Preferably, elemental analysis is used to determine the elemental composition of the porous particles alone and the composition of the composite particles.

Silicon content is preferably determined by ICP-OES (Inductively coupled plasma-optical emission spectrometry). A number of ICP-OES instruments are commercially available, such as the iCAP® 7000 series of ICP-OES analysers available from ThermoFisher Scientific. The carbon content of the composite particles and of the porous carbon particles alone (as well as the hydrogen, nitrogen and oxygen content if required) are preferably determined by IR absorption. A suitable instrument for determining carbon, hydrogen, nitrogen and oxygen content is the TruSpec® Micro elemental analyser available from Leco Corporation.

Preferably at least 90 wt%, more preferably at least 95 wt%, even more preferably at least 98 wt% of the electroactive material in the composite particles is located within the internal pore volume of the porous particles such that there is no or very little electroactive material located on the external surfaces of the composite particles. As discussed above, deposition of electroactive material in a CVI process occurs at the surfaces of the porous particles. In view of the very high internal surface area of the porous particles, the reaction kinetics of the CVI process ensure that deposition of the electroactive material occurs almost entirely within the pores of the porous particles. The internal deposition of the electroactive material is further improved by the requirement that the pressure in at least one of the steps (b) and (d) is maintained at less than 200 kPa, or within the preferred pressure ranges discussed above.

The process of the invention optionally further comprises the step:

(e) forming a plurality of modifier material domains in the pores and/or on the outer surface of the composite particles from step (d).

Step (e) is carried out immediately after the final electroactive material deposition step (i.e. step (d), or the final repetition of step (d) in the case that steps (c) and (d) are repeated). The formation or modifier material domains in step (e) is analogous to step (c) as described above, except that step (e) is performed after the final electroactive material deposition step (the final step (d)), whereas step (c) is performed between consecutive electroactive material deposition steps. Any of the modifier materials and deposition conditions disclosed herein in relation to step (c) also apply to step (e).

The modifier material domains formed in step (e) may comprise the same or different modifier materials from the modifier material domains formed in step (c).

Optionally, step (e) comprises contacting the composite particles from step (d) with a passivating agent. Preferred passivating agents and passivation conditions as set out above in relation to step (c) also apply to passivation in step (e).

Optionally, step (e) comprises depositing a lithium ion permeable material into the pores and/or onto the outer surface of the composite particles from step (d). This provides a further improvement in the performance of the composite particles when used as an electroactive material for lithium-ion batteries, by reducing the surface area of the composite particles and by sealing the electroactive material domains away from electrolyte access.

A lithium ion permeable material may be deposited immediately after the final electroactive material deposition step (i.e. step (d), or after the final step (d) in the event that steps (c) and (d) are repeated one or more times. Alternatively, a lithium ion permeable material may be deposited after first carrying out a passivation step in step (e) as discussed above.

A suitable lithium ion permeable material is a pyrolytic carbon material. A pyrolytic carbon material may be obtained by a chemical vapour infiltration (CVI) method, i.e. by thermal decomposition of a volatile carbon-containing gas (e.g. ethylene) onto the surface of the composite particles.

A suitable process for depositing a pyrolytic carbon material comprises combining the composite particles from the step (d) with a pyrolytic carbon precursor; and heating the pyrolytic carbon precursor to a temperature effective to cause the deposition of a pyrolytic conductive carbon material into the pores and/or onto the outer surface of the composite particles.

Preferred pyrolytic carbon precursors and pyrolysis conditions as set out above in relation to step (c) also apply to formation of a pyrolytic carbon material in step (e).

In the case that the lithium-ion permeable material is a pyrolytic carbon material, the same compound may function as both a passivating agent and as a pyrolytic carbon precursor in step (e). Suitable conditions for passivating and forming a pyrolytic carbon material using the same compound as the passivating agent and the pyrolytic carbon precursor

in step (e) are the same as those described above in relation to step (c).

Alternatively, different compounds may be used as the passivating agent and as the pyrolytic carbon precursor in step (e). For example, the passivating agent could be styrene, and the pyrolytic carbon precursor could be a compound such as cyclohexane which is capable of forming a pyrolytic carbon material but is not capable of passivating the electroactive material surface.

Composite particles obtained by the process of the invention can be characterised by their performance under thermogravimetric analysis (TGA) in air. This method of analysis relies on the principle that a weight gain is observed when electroactive materials are oxidized in air and at elevated temperature.

As defined herein, "surface silicon" is calculated from the initial mass increase in the TGA trace from a minimum between 150 °C and 500 °C to the maximum mass measured in the temperature range between 550 °C and 650 °C, wherein the TGA is carried out in air with a temperature ramp rate of 10 °C/min. This mass increase is assumed to result from the oxidation of surface silicon and therefore allows the percentage of surface silicon as a proportion of the total amount of silicon to be determined according to the following formula:

$$Y = 1.875 \times [(M_{max} - M_{min}) / M_f] \times 100\%$$

Wherein Y is the percentage of surface silicon as a proportion of the total silicon in the sample, $M_{max}$ is the maximum mass of the sample measured in the temperature range between 550 °C to 650 °C, $M_{min}$ is the minimum mass of the sample above 150 °C and below 500 °C, and $M_f$ is the mass of the sample at completion of oxidation at 1400 °C. For completeness, it will be understood that 1.875 is the molar mass ratio of $SiO_2$ to $O_2$ (i.e. the mass ratio of $SiO_2$ formed to the mass increase due to the addition of oxygen). Typically, the TGA analysis is carried out using a sample size of 10 mg ±2 mg.

One advantage of the process of the invention is that the low pressure CVI step results in composite particles having a high content of as determined by the TGA method described above. As a result, reversible capacity retention over multiple charge/discharge cycles is considerably improved. In the composite particles prepared according to the process of the invention, the surface silicon content is generally at least 20 wt% of the total amount of silicon in the composite particles and may be at least 22 wt%, or at least 25 wt%, at least 30 wt% of the silicon, or at least 35 wt% of the silicon, or at least 40 wt% of the silicon, or at least 45 wt% of the total amount of silicon in the composite particles.

In addition to the surface silicon content, the silicon-containing composite particles obtained by the process of the invention have a low content of coarse bulk silicon as determined by TGA. Coarse bulk silicon is defined herein as silicon which undergoes oxidation above 800 °C as determined by TGA, wherein the TGA is carried out in air with a temperature ramp rate of 10 °C/min. The coarse bulk silicon content is therefore determined according to the following formula:

$$Z = 1.875 \times [(M_f - M_{800}) / M_f] \times 100\%$$

Wherein Z is the percentage of unoxidized silicon at 800 °C, $M_{800}$ is the mass of the sample at 800 °C, and $M_f$ is the mass of ash at completion of oxidation at 1400 °C. For the purposes of this analysis, it is assumed that any mass increase above 800 °C corresponds to the oxidation of silicon to $SiO_2$ and that the total mass at completion of oxidation is $SiO_2$.

Silicon that undergoes oxidation above 800 °C is less desirable. In the composite particles prepared according to the process of the invention, the coarse bulk silicon content is generally no more than 10 wt% of the total amount of silicon in the composite particles, and may be no more than 8 wt%, or no more than 6 wt%, or no more than 5 wt%, or no more than 4 wt%, or no more than 3 wt%, or no more than 2 wt%, or no more than 1.5 wt% of the total amount of silicon in the composite particles..

Preferably, at least 30 wt% of the silicon is surface silicon and no more than 10 wt% of the silicon is coarse bulk silicon, wherein both are determined by TGA. More preferably, at least 35 wt% of the silicon is surface silicon and no more than 8 wt% of the silicon is coarse bulk silicon, wherein both are determined by TGA. More preferably, at least 40 wt% of the silicon is surface silicon and no more than 5 wt% of the silicon is coarse bulk silicon, wherein both are determined by TGA. More preferably, at least 45 wt% of the silicon is surface silicon and no more than 2 wt% of the silicon is coarse bulk silicon, wherein both are determined by TGA.

The composite particles obtained according to the process of the invention preferably have a BET surface area of no more than 300 $m^2/g$, or no more than 250 $m^2/g$, or no more than 200 $m^2/g$, or no more than 150 $m^2/g$. More preferably, no more than 100 $m^2/g$, or no more than 80 $m^2/g$, or no more than 60 $m^2/g$, or no more than 40 $m^2/g$, or no more than 30 $m^2/g$, or no more than 25 $m^2/g$, or no more than 20 $m^2/g$, or no more than 15 $m^2/g$, or no more than 10 $m^2/g$, or no more than 5 $m^2/g$. In general, a low BET surface area is preferred in order to minimize the formation of solid electrolyte interphase (SEI) layers at the surface of the composite particles during the first charge-discharge cycle of an anode. However, a BET surface area which is excessively low results in unacceptably low charging rate and capacity due to the inaccessibility of the bulk of the electroactive material to metal ions in the surrounding electrolyte. The BET surface area is preferably at least 0.1 $m^2/g$, or at

least 1 $m^2/g$, or at least 2 $m^2/g$, or at least 5 $m^2/g$. For instance, the BET surface area of the composite particles may be in the range from 0.1 to 100 $m^2/g$, or from 0.1 to 80 $m^2/g$, or from 0.5 to 60 $m^2/g$, or from 0.5 to 40 $m^2/g$, or from 1 to 30 $m^2/g$, or from 1 to 25 $m^2/g$, or from 2 to 20 $m^2/g$.

The process of the reaction may be carried out using any reactor that is capable of contacting solids and gases at elevated temperature. The porous particles and the forming composite particles may be present in the reactor in the form of a static bed of particles, or in the form of a moving or agitated bed of particles.

In a second aspect, the invention provides composite particles that are obtainable according to the process of the first aspect of the invention.

In a third aspect of the invention, there is provided a composition comprising composite particles according to the second aspect of the invention and at least one other component. In particular, there is provided a composition comprising composite particles according to the second aspect of the invention and at least one other component selected from: (i) a binder; (ii) a conductive additive; and (iii) an additional particulate electroactive material. The composition according to the third aspect of the invention is useful as an electrode composition, and thus may be used to form the active layer of an electrode.

The composition may be a hybrid electrode composition which comprises the composite particles and at least one additional particulate electroactive material. Examples of additional particulate electroactive materials include graphite, hard carbon, silicon, tin, germanium, aluminium and lead. The at least one additional particulate electroactive material is preferably selected from graphite and hard carbon, and most preferably the at least one additional particulate electroactive material is graphite.

In the case of a hybrid electrode composition, the composition preferably comprises from 3 to 60 wt%, or from 3 to 50 wt%, or from 5 to 50 wt%, or from 10 to 50 wt%, or from 15 to 50 wt%, of the composite particles according to the second aspect of the invention, based on the total dry weight of the composition.

The at least one additional particulate electroactive material is suitably present in an amount of from 20 to 95 wt%, or from 25 to 90 wt%, or from 30 to 750 wt% of the at least one additional particulate electroactive material.

The at least one additional particulate electroactive material preferably has a $D_{50}$ particle diameter in the range from 10 to 50 μm, preferably from 10 to 40 μm, more preferably from 10 to 30 μm and most preferably from 10 to 25 μm, for example from 15 to 25 μm.

The $D_{10}$ particle diameter of the at least one additional particulate electroactive material is preferably at least 5 μm, more preferably at least 6 μm, more preferably at least 7 μm, more preferably at least 8 μm, more preferably at least 9 μm, and still more preferably at least 10 μm.

The $D_{90}$ particle diameter of the at least one additional particulate electroactive material is preferably up to 100 μm, more preferably up to 80 μm, more preferably up to 60 μm, more preferably up to 50 μm, and most preferably up to 40 μm.

The at least one additional particulate electroactive material is preferably selected from carbon-comprising particles, graphite particles and/or hard carbon particles, wherein the graphite and hard carbon particles have a $D_{50}$ particle diameter in the range from 10 to 50 μm. Still more preferably, the at least one additional particulate electroactive material is selected from graphite particles, wherein the graphite particles have a $D_{50}$ particle diameter in the range from 10 to 50 μm.

The composition may also be a non-hybrid (or "high loading") electrode composition which is substantially free of additional particulate electroactive materials. In this context, the term "substantially free of additional particulate electroactive materials" should be interpreted as meaning that the composition comprises less than 15 wt%, preferably less than 10 wt%, preferably less than 5 wt%, preferably less than 2 wt%, more preferably less than 1 wt%, more preferably less than 0.5 wt% of any additional electroactive materials (i.e. additional materials which are capable of inserting and releasing metal ions during the charging and discharging of a battery), based on the total dry weight of the composition.

A "high-loading" electrode composition of this type preferably comprises at least 50 wt%, or at least 60 wt%, or at least 70 wt%, or at least 80 wt%, or at least 90 wt% of the composite particles of the second aspect of the invention, based on the total dry weight of the composition.

The composition may optionally comprise a binder. A binder functions to adhere the composition to a current collector and to maintain the integrity of the composition. Examples of binders which may be used in accordance with the present invention include polyvinylidene fluoride (PVDF), polyacrylic acid (PAA) and alkali metal salts thereof, modified polyacrylic acid (mPAA) and alkali metal salts thereof, carboxymethylcellulose (CMC), modified carboxymethylcellulose (mCMC), sodium carboxymethylcellulose (Na-CMC), polyvinylalcohol (PVA), alginates and alkali metal salts thereof, styrene-butadiene rubber (SBR) and polyimide. The composition may comprise a mixture of binders. Preferably, the binder comprises polymers selected from polyacrylic acid (PAA) and alkali metal salts thereof, and modified polyacrylic acid (mPAA) and alkali metal salts thereof, SBR and CMC.

The binder may suitably be present in an amount of from 0.5 to 20 wt%, preferably 1 to 15 wt%, preferably 2 to 10 wt% and most preferably 5 to 10 wt%, based on the total dry weight of the composition.

The binder may optionally be present in combination with one or more additives that modify the properties of the

binder, such as cross-linking accelerators, coupling agents and/or adhesive accelerators.

The composition may optionally comprise one or more conductive additives. Preferred conductive additives are non-electroactive materials that are included so as to improve electrical conductivity between the electroactive components of the composition and between the electroactive components of the composition and a current collector. The conductive additives may be selected from carbon black, carbon fibers, carbon nanotubes, graphene, acetylene black, ketjen black, metal fibers, metal powders and conductive metal oxides. Preferred conductive additives include carbon black and carbon nanotubes.

The one or more conductive additives may suitably be present in a total amount of from 0.5 to 20 wt%, preferably 1 to 15 wt%, preferably 2 to 10 wt% and most preferably 5 to 10 wt%, based on the total dry weight of the composition.

In a fourth aspect, the invention provides an electrode comprising composite particles according to the second aspect of the invention in electrical contact with a current collector. The particulate material used to prepare the electrode of the fourth aspect of the invention may be in the form of a composition according to the third aspect of the invention.

As used herein, the term current collector refers to any conductive substrate that is capable of carrying a current to and from the electroactive particles in the composition. Examples of materials that can be used as the current collector include copper, aluminium, stainless steel, nickel, titanium and sintered carbon. Copper is a preferred material. The current collector is typically in the form of a foil or mesh having a thickness of between 3 to 500 μm. The particulate materials of the invention may be applied to one or both surfaces of the current collector to a thickness which is preferably in the range from 10 μm to 1 mm, for example from 20 to 500 μm, or from 50 to 200 μm.

The electrode of the fourth aspect of the invention may be fabricated by combining the particulate material of the invention with a solvent and optionally one or more viscosity modifying additives to form a slurry. The slurry is then cast onto the surface of a current collector and the solvent is removed, thereby forming an electrode layer on the surface of the current collector. Further steps, such as heat treatment to cure any binders and/or calendaring of the electrode layer may be carried out as appropriate. The electrode layer suitably has a thickness in the range from 20 μm to 2 mm, preferably 20 μm to 1 mm, preferably 20 μm to 500 μm, preferably 20 μm to 200 μm, preferably 20 μm to 100 μm, preferably 20 μm to 50 μm.

Alternatively, the slurry may be formed into a freestanding film or mat comprising the particulate material of the invention, for instance by casting the slurry onto a suitable casting template, removing the solvent and then removing the casting template. The resulting film or mat is in the form of a cohesive, freestanding mass that may then be bonded to a current collector by known methods.

The electrode of the fourth aspect of the invention may be used as the anode of a metal-ion battery. Thus, in a fifth aspect, the present invention provides a rechargeable metal-ion battery comprising an anode, the anode comprising an electrode as described above, a cathode comprising a cathode active material capable of releasing and reabsorbing metal ions; and an electrolyte between the anode and the cathode.

The metal ions are preferably lithium ions. More preferably, the rechargeable metal-ion battery of the invention is a lithium-ion battery, and the cathode active material is capable of releasing and accepting lithium ions.

The cathode active material is preferably a metal oxide-based composite. Examples of suitable cathode active materials include $LiCoO_2$, $LiCo_{0.99}Al_{0.01}O_2$, $LiNiO_2$, $LiMnO_2$, $LiCo_{0.5}Ni_{0.5}O_2$, $LiCo_{0.7}Ni_{0.3}O_2$, $LiCO_{0.8}Ni_{0.2}O_2$, $LiCo_{0.82}Ni_{0.18}O_2$, $LiCo_{0.8}Ni_{0.15}Al_{0.05}O_2$, $LiNi_{0.4}Co_{0.3}Mn_{0.3}O_2$ and $LiNi_{0.33}Co_{0.33}Mn_{0.34}O_2$. The cathode current collector is generally of a thickness of between 3 to 500 μm. Examples of materials that can be used as the cathode current collector include aluminium, stainless steel, nickel, titanium and sintered carbon.

The electrolyte is suitably a non-aqueous electrolyte containing a metal salt, e.g. a lithium salt, and may include, without limitation, non-aqueous electrolytic solutions, solid electrolytes and inorganic solid electrolytes. Examples of non-aqueous electrolyte solutions that can be used include non-protic organic solvents such as propylene carbonate, ethylene carbonate, butylene carbonates, dimethyl carbonate, diethyl carbonate, gamma butyrolactone, 1,2-dimethoxyethane, 2-methyltetrahydrofuran, dimethylsulfoxide, 1,3-dioxolane, formamide, dimethylformamide, acetonitrile, nitromethane, methylformate, methyl acetate, phosphoric acid triesters, trimethoxymethane, sulfolane, methyl sulfolane and 1,3-dimethyl-2-imidazolidinone.

Examples of organic solid electrolytes include polyethylene derivatives polyethyleneoxide derivatives, polypropylene oxide derivatives, phosphoric acid ester polymers, polyester sulfide, polyvinylalcohols, polyvinylidine fluoride and polymers containing ionic dissociation groups.

Examples of inorganic solid electrolytes include nitrides, halides and sulfides of lithium salts such as $LisNI_2$, $Li_3N$, LiI, $LiSiO_4$, $Li_2SiS_3$, $Li_4SiO_4$, LiOH and $Li_3PO_4$.

The lithium salt is suitably soluble in the chosen solvent or mixture of solvents. Examples of suitable lithium salts include LiCl, LiBr, LiI, $LiClO_4$, $LiBF_4$, $LiBC_4O_8$, $LiPF_6$, $LiCF_3SO_3$, $LiAsF_6$, $LiSbF_6$, $LiAlCl_4$, $CH_3SO_3Li$ and $CF_3SO_3Li$.

Where the electrolyte is a non-aqueous organic solution, the metal-ion battery is preferably provided with a separator interposed between the anode and the cathode. The separator is typically formed of an insulating material having high ion permeability and high mechanical strength. The separator typically has a pore diameter of between 0.01 and 100 μm and a thickness of between 5 and 300 μm. Examples of suitable electrode separators include a micro-porous

polyethylene film.

The separator may be replaced by a polymer electrolyte material and in such cases the polymer electrolyte material is present within both the composite anode layer and the composite cathode layer. The polymer electrolyte material can be a solid polymer electrolyte or a gel-type polymer electrolyte.

Further disclosure of the invention is provided by the following numbered embodiments.

Embodiment 1. A process for preparing composite particles, the process comprising the steps of:

(a) providing a plurality of porous particles comprising micropores and/or mesopores, wherein the total pore volume of micropores and mesopores as measured by nitrogen gas adsorption is in the range from 0.4 to 2.2 $cm^3/g$;
(b) contacting the porous particles with a precursor of an electroactive material at a temperature effective to cause deposition of the electroactive material in the pores of the porous particles to form intermediate particles;
(c) discontinuing deposition of the electroactive material and separating by-products from the intermediate particles;
(d) contacting the intermediate particles from step (c) with a precursor of an electroactive material, at a temperature effective to cause further deposition of the electroactive material in the pores of the intermediate particles;

wherein the pressure in at least one of steps (b) and (d) is maintained at less than 200 kPa.

Embodiment 2. A process according to embodiment 1, wherein the porous particles comprise a conductive material.

Embodiment 3. A process according to embodiment 1 or embodiment 2, wherein the porous particles comprise a conductive carbon material.

Embodiment 4. A process according to any preceding embodiment, wherein the porous particles have a total volume of micropores and mesopores in the range from 0.45 to 2.2 $cm^3/g$, or from 0.5 to 2 $cm^3/g$, or from 0.55 to 2 $cm^3/g$, or from 0.6 to 1.8 $cm^3/g$, or from 0.65 to 1.8 $cm^3/g$, or from 0.7 to 1.6 $cm^3/g$, or from 0.7 to 1.5 $cm^3/g$, or from 0.7 to 1.4 $cm^3/g$.

Embodiment 5. A process according to any preceding embodiment, wherein the $PD_{50}$ pore diameter of the porous particles is no more than 30 nm, or no more than 25 nm, or no more than 20 nm, or no more than 15 nm, or no more than 12 nm, or no more than 10 nm, or no more than 8 nm, or no more than 6 nm, or no more than 5 nm, or no more than 4 nm, or no more than 3 nm, or no more than 2.5 nm, or no more than 2 nm, or no more than 1.5 nm.

Embodiment 6. A particulate material according to any preceding embodiment, wherein the $PD_{30}$ pore diameter of the porous particle framework is no more than 25 nm, or no more than 20 nm, or no more than 15 nm, or no more than 12 nm, or no more than 10 nm, or no more than 8 nm, or no more than 6 nm, or no more than 5 nm, or no more than 4 nm, or no more than 3 nm, or no more than 2.5 nm, or no more than 2 nm, or no more than 1 nm.

Embodiment 7. A process according to any preceding embodiment, wherein the porous particles have a $D_{50}$ particle diameter in the range from 0.5 to 30 μm, or from 1 to 25 μm, or from 1 to 20 μm, or from 2 to 25 μm, or from 2 to 20 μm, or from 2 to 18 μm, or from 2 to 15 μm, or from 2 to 12 μm, or from 2.5 to 15 μm, or from 2.5 to 12 μm, or from 2 to 10 μm.

Embodiment 8. A process according to any preceding embodiment, wherein the volumetric ratio of micropores to mesopores in the porous particles is from 90:10 to 55:45, or from 90:10 to 60:40, or from 85:15 to 65:35.

Embodiment 9. A process according to any preceding embodiment, wherein the porous particles have a BET surface area in the range from 100 $m^2/g$ to 4,000 $m^2/g$, or from 500 $m^2/g$ to 4,000 $m^2/g$, or from 750 $m^2/g$ to 3,500 $m^2/g$, or from 1,000 $m^2/g$ to 3,250 $m^2/g$, or from 1,000 $m^2/g$ to 3,000 $m^2/g$, or from 1,000 $m^2/g$ to 2,500 $m^2/g$, or from 1,000 $m^2/g$ to 2,000 $m^2/g$.

Embodiment 10. A process according to any preceding embodiment, wherein the electroactive material deposited in steps (b) and (d) is independently selected from silicon, tin, germanium, aluminium and mixtures and alloys thereof, preferably wherein the electroactive material deposited in at least one of steps (b) and (d) the electroactive material is silicon.

Embodiment 11. A process according to any preceding embodiment, wherein the electroactive material deposited in each of steps (b) and (d) is the same electroactive material, preferably wherein the electroactive material deposited in each of steps (b) and (d) is silicon

Embodiment 12. A process according to embodiment 10 or embodiment 11, wherein the silicon-containing precursor is selected from silane ($SiH_4$), disilane ($Si_2H_6$), trisilane ($Si_3H_8$),tetrasilane ($Si_4H_{10}$), methylsilane, dimethylsilane and chlorosilanes.

Embodiment 13. A process according to any preceding embodiment, wherein the temperature in steps (b) and (d) is independently in the range from 300 to 800 °C, or from 350 to 800 °C, or 400 to 700 °C, or from 400 to 650 °C, or from 400 to 600 °C, or from 400 to 550 °C, or from 400 to 500 °C, or from 400 to 450 °C, or from 450 to 500 °C, or from 350 to 500 °C, or from 350 to 450 °C, or from 380 to 450 °C.

Embodiment 14. A process according to any preceding embodiment, wherein the pressure in at least one of steps (b) and (d) is maintained at or below 150 kPa, or at or below 120 kPa, or at or below 110 kPa, or at or below 100 kPa, or at or below 90 kPa, or at or below 80 kPa, or at or below 70 kPa, or at or below 60 kPa, or at or below 50 kPa.

Embodiment 15. A process according to embodiment 14, wherein the pressure in at least step (b) is maintained at or below 150 kPa, or at or below 120 kPa, or at or below 110 kPa, or at or below 100 kPa, or at or below 90 kPa, or at or below 80 kPa, or at or below 70 kPa, or at or below 60 kPa, or at or below 50 kPa.

Embodiment 16. A process according to any preceding embodiment, wherein step (c) comprises separating by-products from the intermediate particles.

Embodiment 17. A process according to any preceding embodiment, wherein step (c) further comprises forming a modifier material on the surface of the electroactive material deposited in step (b).

Embodiment 18. A process according to embodiment 17, wherein step (c) comprises contacting the intermediate particles from step (b) with a passivating agent.

Embodiment 19. A process according to embodiment 18, wherein the passivating agent is selected from (i) an oxygen containing gas; (ii) ammonia; (iii) a gas comprising ammonia and oxygen; and (iv) phosphine.

Embodiment 20. A process according to embodiment 17, wherein the passivating agent is selected from:

(i) $R^1$-CH=CH-$R^1$;
(ii) $R^1$-C≡C-$R^1$;
(iii) O=C$R^1R^1$;
(iv) HX-$R^2$, and
(v) HX-C(O)-$R^1$,

wherein X represents O, S, N$R^1$ or P$R^1$; and
wherein each $R^1$ independently represents H or an unsubstituted or substituted aliphatic or aromatic hydrocarbyl group having from 1 to 20 carbon atoms, or wherein two $R^1$ groups form an unsubstituted or substituted ring structure comprising from 3 to 8 carbon atoms in the ring;
wherein $R^2$ represents an unsubstituted or substituted aliphatic or aromatic hydrocarbyl group having from 1 to 20 carbon atoms, or wherein $R^1$ and $R^2$ together form an unsubstituted or substituted ring structure comprising from 3 to 8 carbon atoms in the ring.

Embodiment 21. A process according to any of embodiments 17 to 20, wherein step (c) comprises contacting the intermediate particles from step (b) with a carbon-containing precursor at a temperature effective to cause deposition of a pyrolytic carbon material in the pores of the intermediate particles.

Embodiment 22. A process according to any preceding embodiment, wherein steps (c) and (d) are repeated one or more times.

Embodiment 23. A process according to any preceding embodiment, further comprising the step of:
(e) forming a plurality of modifier material domains in the pores and/or on the outer surface of the composite particles

from step (d).

Embodiment 24. A process according to embodiment 23, wherein step (e) comprises contacting the surface of the composite particles from the final step (d) with a passivating agent, optionally wherein the passivating agent is as defined in embodiment 19 or embodiment 20.

Embodiment 25. A process according to embodiment 23 or embodiment 24, wherein step (e) comprises combining the composite particles from step (d) with a pyrolytic carbon precursor; and heating the pyrolytic carbon precursor to a temperature effective to cause the deposition of a pyrolytic conductive carbon material into the pores and/or onto the outer surface of the composite particles.

Embodiment 26. Composite particles obtainable by the process of any one of embodiments 1 to 25.

Embodiment 27. A composition comprising the composite particles of embodiment 26 and at least one other component.

Embodiment 28. An electrode comprising the composite particles of embodiment 26 or the composition of embodiment 27.

Embodiment 29. A rechargeable metal-ion battery comprising the electrode of embodiment 28.

**Claims**

**1.** A process for preparing composite particles, the process comprising the steps of:

(a) providing a plurality of porous particles comprising micropores and/or mesopores, wherein the total pore volume of micropores and mesopores as measured by nitrogen gas adsorption is in the range from 0.4 to 2.2 $cm^3/g$, wherein the porous particles have a particle size distribution span of 5 or less, wherein the particle size distribution span is defined as $((D_{90} - D_{10})/D_{50})$, $D_{90}$ refers to the 90th percentile volume-based median particle diameter, $D_{10}$ refers to the 10th percentile volume-based median particle diameter and $D_{50}$ refers to the volume-based median particle diameter;
(b) contacting the porous particles with a precursor of an electroactive material at a temperature effective to cause deposition of the electroactive material in the pores of the porous particles to form intermediate particles;
(c) discontinuing deposition of the electroactive material and separating by-products from the intermediate particles;
(d) contacting the intermediate particles from step (c) with a precursor of an electroactive material, at a temperature effective to cause further deposition of the electroactive material in the pores of the intermediate particles;

wherein the pressure in at least one of steps (b) and (d) is maintained at less than 200 kPa.

**2.** A process according to claim 1, wherein the porous particles have a $D_{50}$ particle diameter in the range from 0.5 to 200 μm, or from 0.5 to 150 μm, or from 0.5 to 100 μm, or from 0.5 to 50 μm, or from 0.5 to 30 μm, or from 1 to 25 μm, or from 1 to 20 μm, or from 2 to 25 μm, or from 2 to 20 μm, or from 2 to 18 μm, or from 2 to 15 μm, or from 2 to 12 μm, or from 2.5 to 15 μm, or from 2.5 to 12 μm, or from 2 to 10 μm, or from 3 to 20 μm, or from 3 to 18 μm, or from 3 to 15 μm, or from 4 to 18 μm, or from 4 to 15 μm, or from 4 to 12 μm, or from 5 to 15 μm, or from 5 to 12 μm or from 5 to 10 μm, or from 5 to 8 μm, wherein the term $D_{50}$ particle diameter refers to the volume-based median particle diameter.

**3.** A process according to claim 1 or claim 2, wherein the porous particles have a particle size distribution span of 4 or less, more preferably 3 or less, more preferably 2 or less, and most preferably 1.5 or less.

**4.** A process according to any preceding claim, wherein the porous particles have an average sphericity of more than 0.5, or at least 0.55, or at least 0.6, or at least 0.65, or at least 0.7, or at least 0.75, or at least 0.8, or at least 0.85, preferably at least 0.90, or at least 0.92, or at least 0.93, or at least 0.94, or at least 0.95.

**5.** A process according to any preceding claim, wherein the porous particles have:

(i) a total pore volume of micropores and mesopores as measured by nitrogen gas adsorption in the range from 0.4 to 2.2 $cm^3/g$;
(ii) a $PD_{50}$ pore diameter of no more than 20 nm, preferably a $PD_{90}$ pore diameter of no more than 30 nm, preferably a $PD_{30}$ pore diameter of no more than 15 nm; and
(iii) a $D_{50}$ particle diameter in the range from 0.5 to 30 $\mu$m.

**6.** A process according to any preceding claim, wherein the porous particles comprise titanium nitride (TiN), titanium carbide (TiC), silicon carbide (SiC), nickel oxide (NiOx), titanium silicon nitride (TiSiN), nickel nitride ($Ni_3N$), molybdenum nitride (MoN), titanium oxynitride ($TiO_xN_{1-x}$), silicon oxycarbide (SiOC), boron nitride (BN), or vanadium nitride (VN), preferably titanium nitride (TiN), silicon oxycarbide (SiOC) or boron nitride (BN).

**7.** A process according to any of claims 1 to 5, wherein the porous particles are conductive porous carbon particles, preferably wherein the conductive porous carbon particles are hard carbon particles or soft carbon particles.

**8.** A process according to claim 7, wherein the conductive porous carbon particles are prepared via pyrolysis of organic materials, preferably wherein the organic materials comprise plant biomass or fossil carbon sources, more preferably wherein the organic materials comprise phenolic resins, novolac resins, pitch, melamines, polyacrylates, polystyrenes, polyvinylalcohol (PVA), polyvinylpyrrolidone (PVP), various copolymers comprising monomer units of acrylates, styrenes, $\alpha$-olefins, vinylpyrrolidone or other ethylenically unsaturated monomers.

**9.** A process according to any preceding claim, wherein the oxygen content of the precursor of an electroactive material in steps (b) and (d) is less than 0.01 vol% based on the total volume of gas used in steps (b) and (d).

**10.** A process according to any preceding claim, wherein the precursor of an electroactive material in steps (b) and (d) is used in pure form or wherein the precursor of an electroactive material in steps (b) and (d) is used in an amount in the range from 1 to 95 vol% when in a diluted mixture with an inert carrier gas.

**11.** A process according to any preceding claim, wherein the electroactive material deposited in steps (b) and (d) is independently selected from silicon, tin, germanium, aluminium and mixtures and alloys thereof, preferably wherein the electroactive material deposited in at least one of steps (b) and (d) the electroactive material is silicon.

**12.** A process according to any preceding claim, wherein the electroactive material deposited in each of steps (b) and (d) is the same electroactive material, preferably wherein the electroactive material deposited in each of steps (b) and (d) is silicon

**13.** A process according to claim 11 or claim 12, wherein the silicon-containing precursor is selected from silane ($SiH_4$), disilane ($Si_2H_6$), trisilane ($Si_3H_8$),tetrasilane ($Si_4H_{10}$), methylsilane, dimethylsilane and chlorosilanes.

**14.** A process according to any preceding claim, wherein step (c) comprises separating by-products from the intermediate particles.

**15.** A process according to any preceding claim, wherein step (c) further comprises forming a modifier material on the surface of the electroactive material deposited in step (b), wherein step (c) comprises contacting the intermediate particles from step (b) with a passivating agent.

**16.** A process according to claim 15, wherein the passivating agent is selected from:

(i) $R^1$-CH=CH-$R^1$; and
(ii) $R^1$-C≡C-$R^1$;

wherein each $R^1$ independently represents H or an unsubstituted or substituted aliphatic or aromatic hydrocarbyl group having from 1 to 20 carbon atoms, or wherein two $R^1$ groups form an unsubstituted or substituted ring structure comprising from 3 to 8 carbon atoms in the ring, preferably wherein the passivating agent is selected from:

(i) $CH_2$=CH-$R^1$; and
(ii) HC≡C-$R^1$;

wherein $R^1$ is defined as above, preferably wherein $R^1$ is unsubstituted.

**17.** A process according to claim 15 or claim 16, wherein step (c) comprises contacting the intermediate particles from step (b) with a carbon-containing precursor at a temperature effective to cause deposition of a pyrolytic carbon material in the pores of the intermediate particles.

**18.** A process according to any preceding claim, wherein steps (c) and (d) are repeated one or more times.

**19.** A process according to any preceding claim, further comprising the step of:
(e) forming a plurality of modifier material domains in the pores and/or on the outer surface of the composite particles from step (d),
wherein step (e) comprises contacting the surface of the composite particles from the final step (d) with a passivating agent, optionally wherein the passivating agent is as defined in claim 16.

**20.** A process according to claim 19, wherein step (e) comprises combining the composite particles from step (d) with a pyrolytic carbon precursor; and heating the pyrolytic carbon precursor to a temperature effective to cause the deposition of a pyrolytic conductive carbon material into the pores and/or onto the outer surface of the composite particles.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2007083155 A
- WO 2020095067 A
- WO 2020128495 A


### Non-patent literature cited in the description


- **WINTER, M. et al.** Insertion Electrode Materials for Rechargeable Lithium Batteries. *Adv. Mater.*, 1998, vol. 10 (10)
- **GUO et al.** *Journal of Materials Chemistry A*, 2013, 14075-14079
- **P.A. WEBB** ; **C. ORR**. Analytical Methods in Fine Particle Technology. Micromeritics Instrument Corporation, 1997